(19) Europäisches Patentamt
European Patent Office
Office européen des brevets

(11) **EP 2 694 988 B1**

(12) **FASCICULE DE BREVET EUROPEEN**

(45) Date de publication et mention de la délivrance du brevet:
**10.12.2014 Bulletin 2014/50**

(21) Numéro de dépôt: **12718299.6**

(22) Date de dépôt: **04.04.2012**

(51) Int Cl.:
*G01R 31/02* *(2006.01)*   *G01R 27/14* *(2006.01)*
*G01R 31/28* *(2006.01)*

(86) Numéro de dépôt international:
**PCT/FR2012/050727**

(87) Numéro de publication internationale:
**WO 2012/136931 (11.10.2012 Gazette 2012/41)**

(54) **PROCEDE ET SYSTEME DE DETECTION D'UN COURT-CIRCUIT AFFECTANT UN CAPTEUR**

VERFAHREN UND SYSTEM ZUR KURZSCHLUSSERFASSUNG IN EINEM SENSOR

METHOD AND SYSTEM FOR SHORT CIRCUIT DETECTION IN A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.04.2011 FR 1152936**

(43) Date de publication de la demande:
**12.02.2014 Bulletin 2014/07**

(73) Titulaire: **Sagem Défense Sécurité**
**75015 Paris (FR)**

(72) Inventeurs:
• **LACOMBE, Bertrand**
  **F-75015 Paris (FR)**

• **GENESTE, Nicolas**
  **F-75015 Paris (FR)**

(74) Mandataire: **Fontenelle, Sandrine et al**
**Cabinet Beau de Loménie**
**158, rue de l'Université**
**75340 Paris Cedex 07 (FR)**

(56) Documents cités:
**EP-A2- 1 903 322      WO-A1-89/10542**
**DE-A1- 4 020 106      GB-A- 2 411 481**
**US-A1- 2006 036 381**

**Description**

Arrière-plan de l'invention

L'invention se rapporte au domaine général des capteurs, tels que par exemple des capteurs de température, de pression, de déplacement, etc.

Elle concerne plus particulièrement la détection d'un court-circuit affectant un capteur dans une chaîne d'acquisition.

L'invention a ainsi une application privilégiée mais non limitative dans le domaine de l'aéronautique, où de nombreux capteurs sont utilisés (par exemple, à bord d'un aéronef).

Il existe, dans l'art antérieur, des techniques permettant de détecter un court-circuit affectant un capteur résistif simple à un potentiel connu, tel que par exemple un court-circuit à la masse ou à la tension d'alimentation. Pour ce type de capteur, un court-circuit à la masse ou à la tension d'alimentation se traduit par une mesure nulle de la résistance du capteur.

Un exemple de mise en oeuvre d'une telle technique est décrit dans le document US 2006/0036381. Dans ce document, la présence d'un court-circuit affectant un capteur résistif est déterminée en fonction de la valeur du rapport entre la somme des tensions aux bornes du capteur et la tension d'alimentation du capteur.

De telles techniques permettent avantageusement d'améliorer les mesures réalisées par des capteurs résistifs simples, tels que notamment des capteurs résistifs de température, du fait d'une fiabilité accrue de ces capteurs.

Toutefois pour des capteurs plus complexes, tels que des capteurs à ponts de jauge, des capteurs inductifs ou des capteurs capacitifs, de telles techniques de détection ne peuvent être appliquées.

Le document WO 89/10542 décrit un système pour surveiller un transducteur ou un capteur qui produit un signal de sortie analogique ou numérique correspondant à un état capté par le transducteur.

Il existe donc un besoin d'un mécanisme simple de détection d'un court-circuit affectant un capteur dans une chaîne d'acquisition, qui puisse être appliqué à une plus large catégorie de capteurs.

Objet et résumé de l'invention

La présente invention répond à ce besoin en proposant un procédé de détection d'un court-circuit affectant un capteur, au moins une borne de ce capteur étant reliée à une résistance de tirage, ce procédé consistant à :

- appliquer, à au moins une résistance de tirage, une tension de polarisation de test comprenant au moins une caractéristique prédéfinie différente d'une caractéristique correspondante d'une tension de polarisation nominale de cette résistance ;
- mesurer la tension différentielle résultante aux bornes du capteur ; et
- en fonction d'au moins une caractéristique de la tension différentielle mesurée correspondant à la caractéristique prédéfinie des tensions de polarisation de test, déterminer si le capteur présente un court-circuit.

Ainsi, l'invention permet de détecter un court-circuit affectant un capteur en faisant varier les tensions de polarisation des résistances de tirage classiquement connectées à ce capteur (aussi connues sous le nom de résistance de « pull-up »), par exemple à l'aide d'un convertisseur numérique-analogique commandé par un coeur numérique d'un système électronique.

Cette variation est mise en oeuvre par application d'une tension de polarisation de test à la résistance de tirage qui comprend au moins une caractéristique prédéfinie différente d'une caractéristique correspondante de la tension de polarisation nominale de cette résistance. On entend ici par tension de polarisation nominale, la tension de polarisation usuellement appliquée à la résistance de tirage pour garantir un fonctionnement « normal » du capteur.

Diverses caractéristiques peuvent différencier la tension de polarisation de test appliquée à la résistance de tirage de sa tension nominale. Ainsi, la nature du signal appliqué peut être différente : par exemple, la tension de polarisation nominale peut correspondre à un signal continu tandis que la tension de polarisation de test comprend une composante de signal alternative à une fréquence prédéterminée. En variante, la tension de polarisation de test peut se distinguer de la tension de polarisation nominale par la valeur de certains de leurs paramètres tels que l'amplitude.

Ainsi, en injectant une tension de polarisation de test appropriée aux résistances de tirage, l'invention permet de différencier des pannes de type court-circuit d'autres configurations du capteur à l'origine de tensions différentielles nulles aux bornes de celui-ci. L'invention permet donc avantageusement de détecter un court-circuit affectant divers types de capteurs, tels que notamment des capteurs résistifs mais également des capteurs plus complexes comme des capteurs inductifs (ex. capteurs LVDT, resolver ou à roue phonique), capacitifs, des capteurs à pont de jauge, à thermocouple, etc.

En outre, il est possible de détecter différents types de court-circuit, à savoir notamment des court-circuits à la masse mécanique (et dont le potentiel électrique peut être inconnu) mais également des court-circuits dits différentiels (c'est-à-dire entre deux fils électriques du capteur).

Plus précisément, dans un mode particulier de réalisation de l'invention on détermine que le capteur présente un court-circuit si la caractéristique de la tension différentielle mesurée est différente d'une caractéristique correspondante attendue pour une tension différentielle mesurée aux bornes du capteur lorsque celui-ci ne présente pas de court-circuit.

On notera que par tension différentielle aux bornes du capteur, on entend ici la différence de potentiels existant entre les deux bornes du capteur. Par souci de simplification, on utilisera également cette terminologie lorsque l'une des bornes du capteur est reliée à la masse.

Selon une première variante de réalisation de l'invention :

- chaque borne du capteur est reliée à une résistance de tirage ;
- pour appliquer la tension de polarisation de test à chaque résistance, on applique aux deux résistances de tirage, un signal alternatif à une fréquence prédéterminée différente d'une fréquence utile du capteur ; et
- on détermine que le capteur présente un court-circuit si la tension différentielle résultante comporte une composante alternative à cette fréquence prédéterminée.

Cette première variante permet avantageusement de détecter un court-circuit à la masse mécanique affectant le capteur considéré. Elle ne nécessite qu'une seule mesure de la tension différentielle, qui peut être réalisée par exemple à l'aide de la chaîne d'acquisition du capteur. Ainsi, cette première variante s'applique à des capteurs dits « flottants » par rapport à la masse, c'est-à-dire, dont le mode commun n'est pas imposé par une excitation ou par un autre dispositif, et sur lequel il est donc possible d'agir.

Dans cette première variante, la fréquence à laquelle le signal alternatif est émis pourra être avantageusement déterminée en fonction des caractéristiques des résistances du tirage ainsi que des contraintes de la chaîne d'acquisition, afin notamment que la tension différentielle puisse être mesurée par celle-ci.

Selon une seconde variante de l'invention, le procédé de détection d'un court-circuit consiste en outre à mesurer une tension différentielle nominale aux bornes du capteur lorsque les résistances de tirage sont alimentées par les tensions de polarisation nominales. Par ailleurs, on détermine que ce capteur présente un court-circuit si la tension différentielle résultante mesurée après application des tensions de polarisation de test est sensiblement égale à la tension différentielle nominale.

Cette seconde variante permet de détecter un court-circuit de type différentiel affectant le capteur.

Dans cette seconde variante, pour appliquer la tension de polarisation de test, on pourra notamment appliquer, à chaque résistance, un signal continu. Ce signal continu aura par exemple une amplitude différente de l'amplitude de la tension de polarisation nominale de la résistance.

Pour appliquer la tension de polarisation de test, on pourra également appliquer, à chaque résistance, un signal alternatif à une fréquence prédéterminée différente d'une fréquence utile du capteur.

Lorsque chaque borne du capteur est reliée à une résistance de tirage, les signaux alternatifs appliqués aux résistances pourront être notamment des signaux sinusoïdaux en opposition de phase.

L'utilisation de signaux alternatifs sinusoïdaux en opposition de phase présente pour avantage de faciliter la détection d'un court-circuit.

L'invention vise également un système de détection d'un court-circuit affectant un capteur, au moins une borne de ce capteur étant reliée à une résistance de tirage, ce système comportant :

- des moyens pour appliquer, à au moins une résistance de tirage, une tension de polarisation de test comprenant au moins une caractéristique prédéfinie différente d'une caractéristique correspondante d'une tension de polarisation nominale de cette résistance ;
- des moyens pour mesurer la tension différentielle résultante aux bornes du capteur ; et
- des moyens pour déterminer, en fonction d'au moins une caractéristique de la tension différentielle mesurée correspondant à la caractéristique prédéfinie des tensions de polarisation de test, si le capteur présente un court-circuit.

Dans un mode particulier de réalisation de l'invention, les moyens pour appliquer les tensions de polarisation de test comprennent un convertisseur numérique analogique.

Brève description des dessins

D'autres caractéristiques et avantages de la présente invention ressortiront de la description faite ci-dessous, en référence aux dessins annexés qui en illustrent des exemples de réalisation dépourvus de tout caractère limitatif. Sur les figures :

- la figure 1 représente dans son environnement, un système de détection conforme à l'invention en mode différentiel, dans un mode particulier de réalisation ;
- les figures 2A et 2B représentent un exemple d'application du système de détection représenté sur la figure 1 pour la détection d'un court-circuit différentiel affectant un capteur ;
- la figure 3 représente les principales étapes d'un procédé de détection d'un court-circuit conforme à l'invention, lorsqu'il est mis en oeuvre par le système représenté sur les figures 2A et 2B ;
- la figure 4 représente un exemple d'application du système de détection représenté sur la figure 1 pour la détection d'un court-circuit à la masse mécanique affectant un capteur ;
- la figure 5 représente les principales étapes d'un procédé de détection d'un court-circuit conforme à l'invention, lorsqu'il est mis en oeuvre par le système représenté sur la figure 4 ; et
- la figure 6 représente un système de détection conforme à l'invention, en mode commun, dans un mode particulier de réalisation.

Description détaillée d'un mode de réalisation

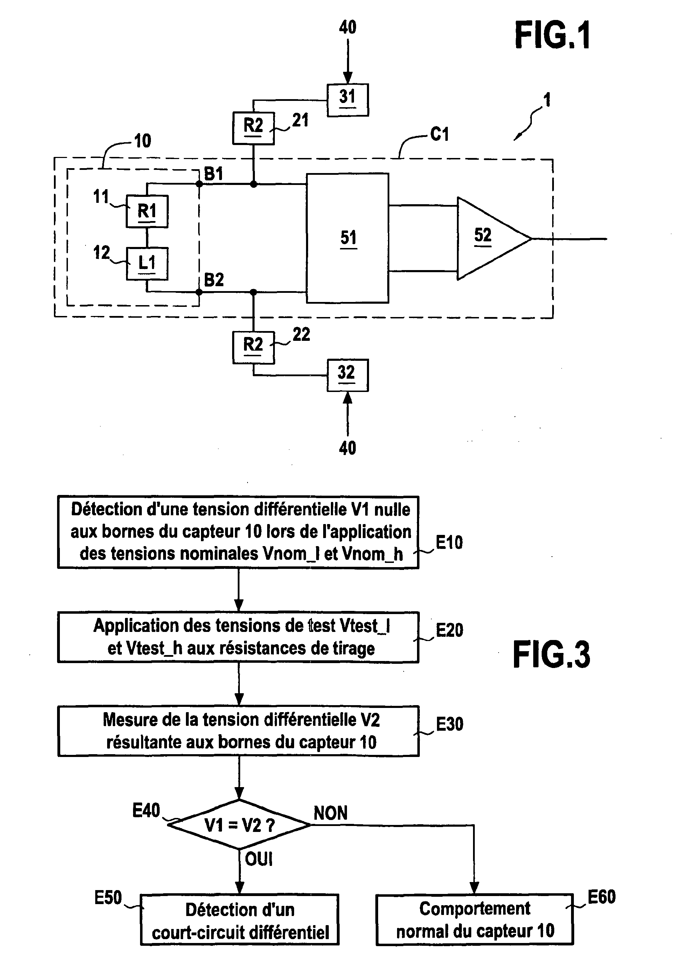

La figure 1 représente, dans son environnement, un système 1 de détection d'un court-circuit, conforme à l'invention, dans un mode particulier de réalisation.

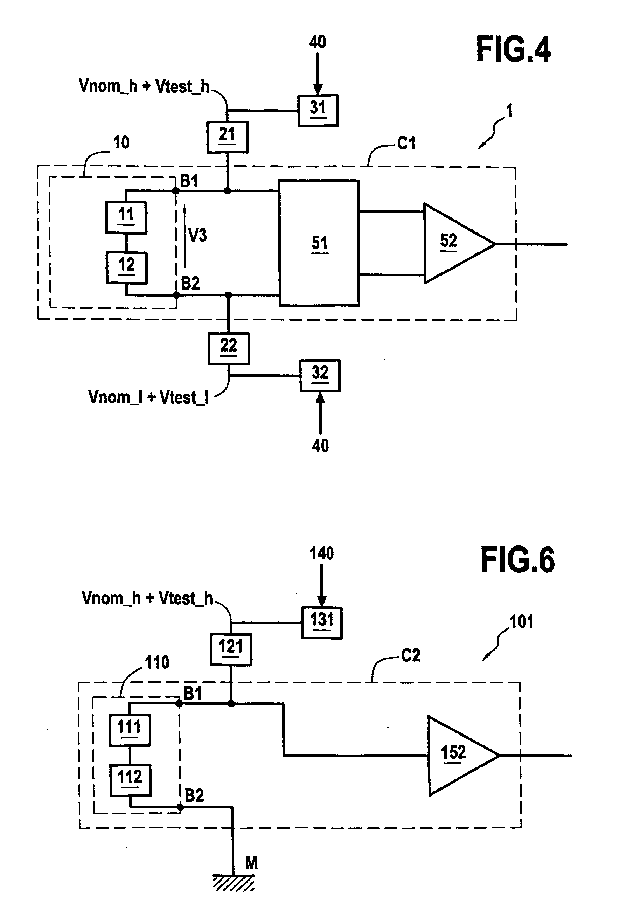

Dans ce mode de réalisation, on envisage de déterminer si un court-circuit affecte un capteur 10 d'une chaîne d'acquisition C1 en mode différentiel. Toutefois, l'invention s'applique également à une chaîne d'acquisition en mode commun, comme décrit ultérieurement en référence à la figure 6.

Le capteur 10 est par exemple un capteur inductif de position ou de déplacement, comprenant au moins un élément résistif 11, caractérisé par une résistance R1, et un élément inductif 12 caractérisé par une inductance L1. Les valeurs de R1 et de L1 peuvent être mesurées au cours d'une étape préalable de calibration du capteur.

Dans la suite de la description, les valeurs minimales des résistances R1 et L1 seront notées L1min et R1min. Ces valeurs dépendent du capteur considéré et sont fournies par le fabricant.

Ces hypothèses ne sont bien entendu pas limitatives, le capteur 10 pouvant être également un capteur résistif ou capacitif, permettant de mesurer d'autres paramètres, telles que la température, la pression, la vitesse, etc.

Les bornes B1 et B2 du capteur 10 sont reliées respectivement à deux résistances dites de tirage 21 et 22, connues de l'homme du métier. La résistance de tirage 21 correspond à un niveau de potentiel haut (en anglais « pull-up resistor »), tandis que la résistance de tirage 22 correspond à un niveau de potentiel bas (en anglais « pull-down resistor »).

Dans l'exemple envisagé ici, les résistances de tirage 21 et 22 sont identiques, et ont une valeur R2. La valeur minimale de la résistance R2 est notée, dans la suite de la description, R2min. En outre, on désigne par Vmax la tension de polarisation maximale pouvant être appliquée aux résistances de tirage 21 et 22 sans endommager le capteur 10. Les valeurs R2min et Vmax dépendent des résistances de tirage considérées et du capteur 10, et sont connues du constructeur.

En variante, des résistances de tirage ayant des valeurs distinctes et supportant des tensions de polarisation maximales et minimales différentes peuvent être considérées. L'homme du métier saurait bien entendu adapter les calculs présentés dans la suite de la description à de tels cas de figure.

On notera que par souci de simplification, dans la suite de la description, les mêmes notations seront utilisées pour désigner indifféremment une tension en régime alternatif (AC pour Alternating Current) ou une tension en régime permanent (DC pour Direct Current), selon les cas envisagés.

Les résistances de tirage 21 et 22 sont connectées respectivement à deux convertisseurs numérique-analogique, 31 et 32, aptes à faire varier leurs tensions de polarisation respectives. Les convertisseurs numérique-analogique 31 et 32 sont eux-mêmes commandés par un coeur numérique 40.

La chaîne d'acquisition C1 du capteur 10 est en outre constituée, de façon connue en soi, d'un filtre mode commun/mode différentiel 51, suivi d'un amplificateur 52, permettant d'améliorer le rapport signal-à-bruit du signal de mesure délivré par le capteur 10. Les éléments constituant une chaîne d'acquisition ainsi que leurs principes de fonctionnement sont connus de l'homme du métier et ne seront pas détaillés davantage ici.

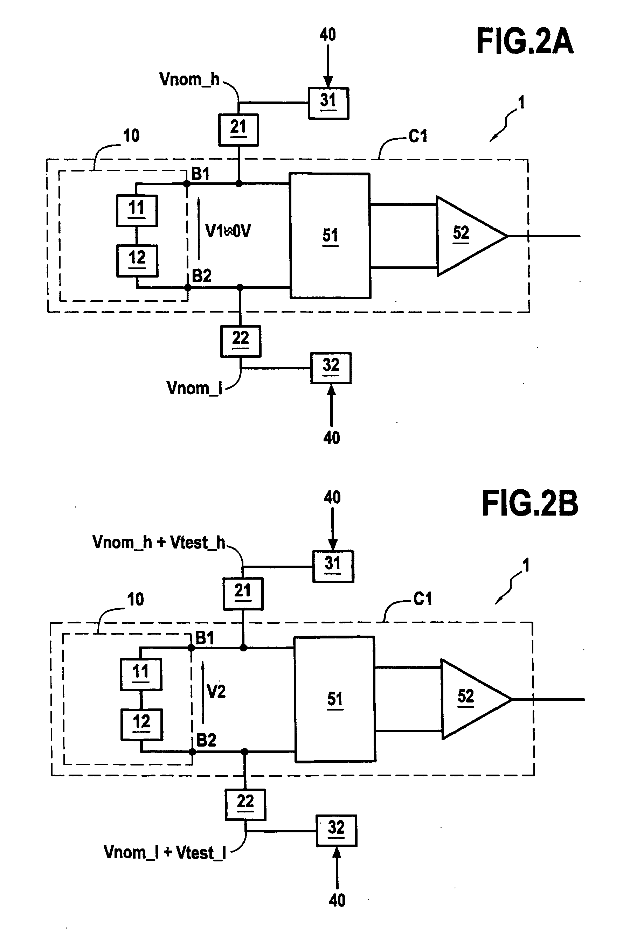

Nous allons maintenant décrire, en référence aux figures **2A, 2B** et 3, un premier exemple d'utilisation du système 1 représenté sur la figure 1 en vue de détecter si un court-circuit différentiel affecte le capteur 10. On entend ici par court-circuit différentiel un court-circuit présent entre deux fils électriques du capteur.

En référence à la figure 2A, on suppose qu'une première mesure V1 de la tension différentielle aux bornes du capteur inductif 10, alors que les résistances de tirage 21 et 22 sont alimentées respectivement par des tensions de polarisation nominales Vnom_h et Vnom_l, donne une valeur proche de 0 Volt (étape E10).

Cette première mesure V1 constitue une tension différentielle nominale au sens de l'invention. Elle est réalisée à l'aide de la chaîne d'acquisition C1 du système 1, de façon connue en soi et non décrite ici.

Les tensions nominales Vnom_h et Vnom_l sont des tensions continues. Elles sont appliquées aux résistances de tirage 21 et 22 par l'intermédiaire des convertisseurs numérique-analogique 31 et 32 respectivement, ces convertisseurs étant commandés par le coeur numérique 40.

Ces tensions nominales représentent les tensions usuellement appliquées aux bornes des résistances de tirage de façon à garantir un fonctionnement normal du capteur 10. Elles dépendent de façon connue des caractéristiques du capteur 10, et peuvent être aisément déterminées par l'homme du métier.

Suite à la détection d'une première mesure différentielle V1 nulle aux bornes du capteur, on applique respectivement aux bornes des résistances de tirage 21 et 22 des tensions de polarisation de test Vtest_h et Vtest_l, par l'intermédiaire des convertisseurs 31 et 32 (étape E20). Conformément à l'invention, les tensions Vtest_h et Vtest_l ont au moins une caractéristique prédéfinie différente d'une caractéristique correspondante des tensions nominales Vnom_h et Vnom_l.

L'application des tensions de polarisation de test Vtest_h et Vtest_l aux résistances de tirage 21 et 22 vise à permettre de déterminer si un court-circuit aux bornes du capteur 10 existe en réalisant une seconde mesure V2 de la tension différentielle résultante aux bornes du capteur. Plus précisément, dans l'exemple envisagé ici, si la caractéristique prédéfinie précédemment mentionnée de la tension différentielle V2 est différente de la caractéristique correspondante attendue pour une tension différentielle mesurée aux bornes du capteur 10 lorsque celui-ci ne présente pas de court-circuit, alors on détermine que le capteur 10 est affecté par un court-circuit.

De façon connue en soi, les résistances de tirage 21 et 22 n'ont pas en principe vocation à perturber le fonctionnement du capteur 10, y compris lors d'un changement d'une ou plusieurs caractéristiques de leurs tensions de polarisation. Aussi, de façon avantageuse dans l'invention, afin d'identifier si un court-circuit différentiel existe, les tensions de test Vtest_h et Vtest_l vont être dimensionnées de sorte à tirer profit d'un défaut des résistances de tirage 21 et 22.

Ce défaut conduit en fait à obtenir une seconde mesure différentielle V2 identique ou quasiment identique (i.e. à un seuil $\varepsilon > 0$ près) à la première mesure différentielle V1 lorsqu'un court-circuit différentiel affectant le capteur 10 existe.

Inversement, si une différence est détectée entre la première mesure différentielle V1 et la seconde mesure différentielle V2, alors cela signifie que, bien qu'une valeur nulle de la tension différentielle V1 ait été mesurée, le capteur 10 se comporte normalement, i.e., il ne présente pas de court-circuit différentiel.

Deux cas de figure sont envisagés pour le dimensionnement des tensions Vtest_l et Vtest_h en fonction de la valeur de l'impédance DC minimale du capteur 10, autrement dit de R1min.

1$^{er}$ cas : L'impédance DC du capteur 10 vérifie l'inégalité suivante :

$$ R1\,min \geq \frac{\dfrac{Vacq\_min}{Vmax} \times R2\,min}{1 - \dfrac{Vacq\_min}{2 \times Vmax}} \qquad (1), $$

dans laquelle Vacq_min désigne la valeur de la tension DC minimale pouvant être mesurée par la chaîne d'acquisition C1, et Vmax la tension DC de polarisation maximale pouvant être appliquée aux résistances de tirage 11 et 12. Ces valeurs sont prédéterminées et connues.

Dans ce premier cas, l'impédance DC du capteur 10 (i.e. R1) est suffisamment importante pour qu'en appliquant comme tensions de polarisation de test Vtest_l et Vtest_h, des signaux continus d'amplitudes supérieures à celles des tensions nominales Vnom_l et Vnom_h, on puisse détecter, à l'aide de la chaîne d'acquisition C1, une différence entre les mesures V1 et V2 lors d'un comportement normal du capteur 10.

Ainsi, dans ce premier cas, la caractéristique prédéfinie de la tension de polarisation de test différente de la caractéristique correspondante de la tension de polarisation nominale au sens de l'invention est l'amplitude.

Préférentiellement, on choisira comme amplitudes des tensions de polarisation de test, des amplitudes proches des valeurs maximales Vmax de tensions de polarisation des résistances de tirage 21 et 22 que le capteur 10 peut supporter sans être endommagé ou détérioré.

La différence entre les mesures V1 et V2 ne doit pas être nécessairement très élevée pour être représentative d'un comportement normal du capteur 10. Une différence même faible est suffisante, dès lors qu'elle est supérieure à la tension Vacq_min minimale pouvant être mesurée par la chaîne d'acquisition C1. Autrement dit, compte tenu de l'inégalité (1) si :

$$ V2 - V1 > \frac{R1\,min}{R1\,min + 2R2\,min} \times 2Vmax $$

le capteur 10 est considéré comme ayant un comportement normal.

A titre d'exemple numérique, pour un capteur de type « strain-gauge », dont l'impédance R1min est de 2kΩ (ohms), et sous les hypothèses suivantes :

$$\text{Vacq\_min=20mV, R2min = 1MΩ, Vmax=20V}$$

une différence de tension (V2-V1) supérieure à environ 40mV est représentative d'un comportement normal du capteur.

On notera que la différence V2-V1 dépend de l'impédance minimale du capteur ainsi que de l'impédance maximale qui sera considérée comme symptomatique d'un court-circuit.

A titre d'exemple, les capteurs à pont de jauge, qui présentent généralement une impédance DC importante par rapport aux impédances des résistances de tirage habituellement utilisées, entrent dans ce premier cas de figure.

$2^{nd}$ cas : Lorsque l'impédance DC du capteur 10 ne vérifie pas l'inégalité (1), l'utilisation de signaux continus pour les tensions de polarisation de test Vtest_l et Vtest_h ne permet pas de détecter, à l'aide de la chaîne d'acquisition C1, une différence même faible entre les mesures V1 et V2 pour un comportement normal du capteur 10. A titre d'exemple, une roue phonique ou un capteur résolveur entrent généralement dans ce second cas de figure.

Dans un tel cas, pour appliquer les tensions de polarisation de test Vtest_l et Vtest_h, on superpose ici aux tensions nominales continues Vnom_l et Vnom_h, des signaux de tension S1 et S1' alternatifs sinusoïdaux et en opposition de phase, à une fréquence prédéterminée $f_1$ distincte de la fréquence utile $f_0$ du capteur 10. Les signaux S1 et S1' sont par exemple de la forme :

$$S1(f_1)=Vmax \cos (2\pi f_1 t) \text{ et } S1'(f_1)=Vmax \cos (2\pi f_1 t+\pi).$$

On notera que d'autres types de signaux peuvent être superposés aux tensions nominales, tels que par exemple des signaux en créneaux ou en triangles.

On entend ici par fréquence utile $f_0$ du capteur la fréquence usuelle de fonctionnement du capteur, qui est prédéfinie et indiquée par le constructeur du capteur.

Ainsi, dans ce second cas, la caractéristique prédéfinie de la tension de polarisation de test différente de la caractéristique correspondante de la tension de polarisation nominale au sens de l'invention est la nature du signal et plus précisément sa composante alternative.

La fréquence $f_1$ est choisie de sorte à obtenir une impédance équivalente minimale Z1eq du capteur 10 suffisamment importante pour permettre la détection d'une différence par la chaîne d'acquisition C1, même faible, entre les mesures V1 et V2 pour un comportement normal du capteur 10. A cette fin, on choisit ici une fréquence $f_1$ comprise entre la fréquence maximale acceptable par le chaîne d'acquisition C1 (prédéterminée), notée fmax, et une fréquence minimale fmin calculée de la façon suivante :

$$f\,min = \frac{1}{2\pi}\sqrt{\frac{\|Z1eq\|^2 - R1min^2}{L1min^2}} \qquad (2)$$

avec

$$Z1eq = \frac{\dfrac{Vacq\_min}{V\,max} \times R2\,min}{1 - \dfrac{Vacq\_min}{2 \times V\,max}} \qquad (3),$$

les tensions considérées dans les équations (2) et (3) désignant les amplitudes des tensions alternatives.

En variante, on peut utiliser dans l'équation (2) les valeurs R1 et L1 à la place des valeurs R1min et L1min, afin d'avoir une estimation plus précise de la fréquence f_min. Comme mentionné précédemment, ces valeurs peuvent être déterminées au cours d'une étape de calibration du capteur 10, connue de l'homme du métier.

A la suite de la l'application des tensions de test Vtest_h et Vtest_l sur les résistances de tirage 21 et 22 respectivement, une seconde mesure V2 de la tension différentielle résultante aux bornes du capteur 10 est réalisée à l'aide de la chaîne d'acquisition C1 (étape E30).

Cette seconde mesure V2 est alors comparée à la première mesure différentielle nominale V1, par exemple par le coeur numérique (étape E40).

Si on détermine au cours de cette comparaison que les tensions nominale et résultante, V1 et V2, sont sensiblement égales, autrement dit qu'elles sont nulles ou quasi-nulles, alors on en déduit qu'un court-circuit différentiel affecte le capteur 10 (étape E50).

En d'autres mots, cela signifie :

- pour les capteurs se trouvant dans le $1^{er}$ cas envisagé précédemment : que l'amplitude mesurée de la tension différentielle V2 est différente de l'amplitude attendue aux bornes du capteur en l'absence de court-circuit (on s'attend en effet à une amplitude différente de l'amplitude de V1 lors d'un comportement normal du capteur, c'est-à-dire en l'absence de court-circuit) ; et
- pour les capteurs se trouvant dans le $2^{nd}$ cas envisagé précédemment : que la tension différentielle V2 ne comporte pas de composante à la fréquence f1, contrairement à la tension différentielle qui devrait être mesurée aux bornes du capteur si celui-ci n'était pas affecté par un court-circuit.

Inversement, si on détermine au cours de cette comparaison que les tensions nominale et résultante V1 et V2 ne sont pas égales (à un seuil $\varepsilon$ près), alors on en déduit que le capteur 10 se comporte normalement lorsqu'une tension différentielle V1 est mesurée à ses bornes, autrement dit qu'il n'est pas affecté d'un court-circuit différentiel (étape E60).

Dans ce premier exemple d'utilisation du système 1, les inégalités (1), (2) et (3) ont été dérivées pour un capteur inductif. Toutefois, l'invention ne se limite pas à ce type de capteur, et s'applique également à des capteurs résistifs ou capacitifs.

On notera d'ailleurs que les inégalités (1), (2) et (3) sont également valables pour un capteur résistif. L'homme du métier n'aurait par ailleurs aucune difficulté à adapter ces inégalités pour un capteur capacitif.

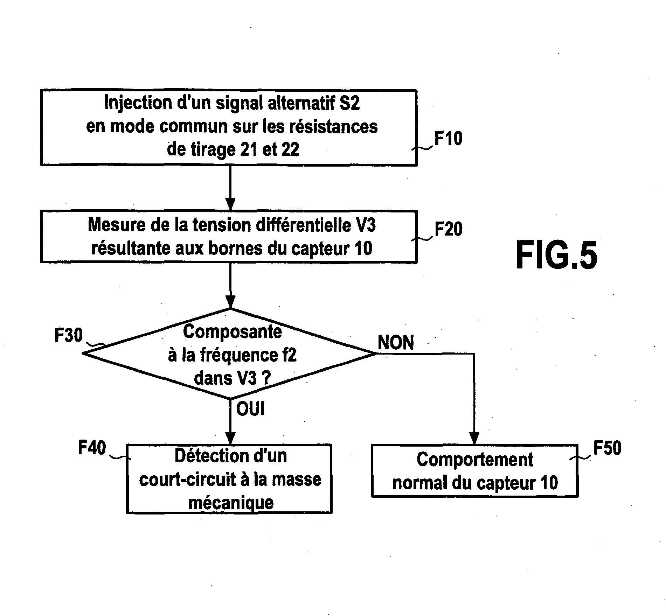

Nous allons maintenant décrire, en référence aux figures 4 et 5, un second exemple d'utilisation du système 1 représenté sur la figure 1, en vue cette fois-ci de détecter si un court-circuit à la masse mécanique affecte le capteur 10. On entend ici par court-circuit à la masse mécanique un court-circuit affectant l'un des fils du capteur 10 relié à un potentiel inconnu, l'autre fil étant relié à la masse.

A cette fin, on injecte en mode commun aux résistances de tirage 21 et 22, par l'intermédiaire des convertisseurs numérique-analogique 31 et 32, un signal de tension sinusoïdal S2 à une fréquence $f_2$ (étape F10). Le signal S2 est par exemple de la forme :

$$S2(f_2) = Vmax \cos (2\pi f_2 t).$$

Ce signal vient, dans l'exemple décrit ici, se superposer aux tensions de polarisation nominales de sorte que :

$$Vtest\_h = Vnom\_h + Vmax \cos (2\pi f_2 t)$$

et

$$Vtest\_l = Vnom\_l + Vmax \cos (2\pi f_2 t),$$

Vnom_h et Vnom_l désignant des tensions de polarisation nominales des résistances de tirage 21 et 22 en régime permanent.

La fréquence $f_2$ est choisie de sorte à respecter les contraintes suivantes :

- le signal injecté ne doit pas générer de perturbation dans le signal à la fréquence utile $f_0$ du capteur ; et
- en cas de court-circuit, on souhaite pouvoir observer un signal à une fréquence autre que la fréquence utile $f_0$ du capteur 10, et que ce signal soit mesurable à l'aide de la chaîne d'acquisition C1.

Plus précisément, comme décrit précédemment pour la fréquence $f_1$ pour le premier exemple d'application, la

fréquence $f_2$ est choisie inférieure à la fréquence maximale acceptable fmax par la chaîne d'acquisition C1 et supérieure à la fréquence minimale fmin donnée par les équations (2) et (3) précédemment définies.

Ainsi, dans cet exemple, la caractéristique prédéfinie de la tension de polarisation de test différente de la caractéristique correspondante de la tension de polarisation nominale au sens de l'invention est la nature du signal, et plus précisément sa composante alternative, si les tensions Vnom_h et Vnom_l sont des tensions continues.

On notera par ailleurs que d'autres types de signaux peuvent être superposés aux tensions nominales, tels que par exemple des signaux en créneaux ou en triangles.

La tension différentielle V3 résultant de l'application des tensions de polarisation de test Vtest_h et Vtest_l sur les résistances de tirage 21 et 22 est alors mesurée à l'aide de la chaîne d'acquisition C1 (étape F20). Puis les caractéristiques de cette tension différentielle V3 sont observées (étape F30).

On notera que pour ces étapes, on utilise avantageusement ici la chaîne d'acquisition C1 du capteur 10, ce qui permet de mettre en oeuvre l'invention de façon simple, sans nécessiter l'utilisation d'équipements supplémentaires. Toutefois, en variante, on pourrait également envisager l'utilisation d'un oscilloscope.

Les tensions de polarisation de test Vtest_h et Vtest_l correspondant à des signaux de même fréquence $f_2$ injectés en mode commun aux deux résistances de tirage 21 et 22, on s'attend, pour un comportement normal du capteur 10, à n'observer aucun signal à la fréquence $f_2$ en sortie du capteur 10.

Ainsi, si l'on observe dans la tension V3 une composante à la fréquence $f_2$, on en déduit alors qu'un court-circuit à la masse mécanique affecte le capteur 10 (étape F40).

Inversement, si aucune composante alternative à la fréquence $f_2$ n'est présente dans la tension V3, on en déduit alors que le capteur 10 a un comportement normal, autrement dit qu'il n'est pas affecté par un court-circuit à la masse mécanique (étape F50).

Il convient de noter que dans les exemples décrits précédemment, les tensions différentielles V1, V2, V3 établies à l'aide la chaîne d'acquisition C1 sont des tensions établies en sortie du filtre 51. Or, de façon connue, la tension différentielle établie en sortie du filtre 51 par la chaîne d'acquisition C1 est l'image de la tension différentielle en entrée du filtre 51 après stabilisation, autrement dit, de la tension différentielle aux bornes du capteur 10 après stabilisation. Les tensions V1, V2 et V3 établies à l'aide de la chaîne d'acquisition C1 sont donc représentatives des tensions différentielles aux bornes du capteur 10.

Les exemples précédents ont été décrits pour une chaîne d'acquisition en mode différentiel. Toutefois, comme mentionné précédemment, l'invention s'applique également à une chaîne d'acquisition en mode commun.

La **figure 6** représente, dans un mode particulier de réalisation de l'invention, un système de détection 101 d'un court-circuit affectant un capteur 110 d'une chaîne d'acquisition C2 en mode commun.

Le capteur 110 est par exemple un capteur inductif de position ou de déplacement, comprenant au moins un élément inductif 111 et un élément résistif 112. Ces hypothèses ne sont bien entendu pas limitatives, le capteur 110 pouvant être en variante un capteur résistif ou capacitif, permettant de détecter d'autres variables, telles que la température, la pression, la vitesse, etc.

En mode commun, l'une des bornes B2 du capteur 110 est reliée à la masse M, tandis que l'autre borne B1 est reliée à une résistance de tirage 121.

La résistance de tirage 121 correspond à un niveau de potentiel haut. Elle est connectée à un convertisseur numérique-analogique 131 apte à faire varier sa tension de polarisation. Le convertisseur numérique-analogique 131 est commandé par un coeur numérique 140.

La chaîne d'acquisition C2 du capteur 110 est en outre constituée, de façon connue en soi, d'un amplificateur 152, permettant d'améliorer le rapport signal-à-bruit du signal de mesure délivré par le capteur 110.

Une telle chaîne d'acquisition C2 en mode commun est souvent considérée lorsque les masses mécanique et électrique sont reliées. Dans ce contexte, un seul cas de court-circuit peut être rencontré au niveau du capteur 110, à savoir un court-circuit différentiel. Ainsi, le système 101 peut être utilisé de façon similaire au système de détection 1 décrit précédemment pour la détection d'un court-circuit différentiel dans le cas où une chaîne en mode différentiel est considérée. Toutefois, le système de détection 101 ne comprenant qu'une seule tension de polarisation, la valeur de l'amplitude de la tension de polarisation de test Vtest_h appliquée devra être deux fois plus importante que dans le cas du système 101 pour permettre une détection d'un court-circuit.

L'invention s'applique de façon privilégiée mais non limitative dans le domaine de l'aéronautique. Elle permet notamment de détecter des court-circuits susceptibles d'affecter les nombreux capteurs présents à bord d'un aéronef, tels que par exemple les capteurs de température, de déplacement, de pression, etc.

On notera qu'en fonction du capteur considéré et de son impédance, ainsi que du type de court-circuit que l'on souhaite détecter, le procédé et le système de détection selon l'invention peuvent être mis en oeuvre lors d'un test en cours d'essai en vol ou au sol, ou en variante, au cours d'un auto-test, notamment lorsqu'un signal de tension alternatif est injecté pour appliquer les tensions de polarisation de test.

**Revendications**

1. Procédé de détection d'un court-circuit affectant un capteur (10,110), au moins une borne (B1,B2) de ce capteur étant reliée à une résistance de tirage (21,22,121), ledit procédé étant **caractérisé en ce qu'**il consiste à :

   - appliquer (E20,F10), à au moins une résistance de tirage (21,22,121), une tension de polarisation de test (Vtest_h,Vtest_l) comprenant au moins une caractéristique prédéfinie différente d'une caractéristique correspondante d'une tension de polarisation nominale (Vnom_h,Vnom_l) de cette résistance, ladite caractéristique prédéfinie étant par exemple un paramètre de la tension telle qu'une amplitude ou une nature continue ou alternative de la tension ;
   - mesurer (E30,F20) la tension différentielle (V2,V3) résultante aux bornes du capteur ; et
   - en fonction d'au moins une caractéristique de la tension différentielle mesurée correspondant à la caractéristique prédéfinie des tensions de polarisation de test (E40,F30), déterminer (E50,E60,F40,F50) si le capteur présente un court-circuit.

2. Procédé de détection d'un court-circuit selon la revendication 1, **caractérisé en ce que** l'on détermine que le capteur présente un court-circuit si la caractéristique de la tension différentielle mesurée est différente d'une caractéristique correspondante attendue pour une tension différentielle mesurée aux bornes du capteur lorsque celui-ci ne présente pas de court-circuit.

3. Procédé de détection d'un court-circuit selon la revendication 1 ou 2, **caractérisé en ce que** :

   - chaque borne (B1,B2) du capteur (10) est reliée à une résistance de tirage (21,22) ;
   - pour appliquer la tension de polarisation de test (Vtest_h,Vtest_l) à chaque résistance, on applique aux deux résistances de tirage (21,22), un signal alternatif à une fréquence prédéterminée différente d'une fréquence utile du capteur ; et
   - on détermine que le capteur présente un court-circuit si la tension différentielle résultante comporte une composante alternative à cette fréquence prédéterminée.

4. Procédé de détection d'un court-circuit selon la revendication 1 ou 2, **caractérisé en ce qu'**il consiste en outre à mesurer une tension différentielle nominale (V1) aux bornes du capteur (B1,B2) lorsque les résistances de tirage (21,22,121) sont alimentées par les tensions de polarisation nominales (Vnom_h,Vnom_l), et **en ce que** l'on détermine (E50) que ce capteur présente un court-circuit si la tension différentielle résultante mesurée après application des tensions de polarisation de test est sensiblement égale à la tension différentielle nominale.

5. Procédé de détection d'un court-circuit selon la revendication 4, **caractérisé en ce que**, pour appliquer la tension de polarisation de test, on applique, à chaque résistance, un signal continu.

6. Procédé de détection d'un court-circuit selon la revendication 5, **caractérisé en ce que**, le signal continu a une amplitude différente de l'amplitude de la tension de polarisation nominale de la résistance.

7. Procédé de détection d'un court-circuit selon la revendication 4, **caractérisé en ce que**, pour appliquer la tension de polarisation de test, on applique, à chaque résistance, un signal alternatif à une fréquence prédéterminée différente d'une fréquence utile du capteur.

8. Procédé de détection d'un court-circuit selon la revendication 7, **caractérisé en ce que** chaque borne du capteur est reliée à une résistance de tirage et **en ce que**, pour appliquer la tension de polarisation de test, les signaux alternatifs appliqués aux résistances sont des signaux sinusoïdaux en opposition de phase.

9. Système (1,101) de détection d'un court-circuit affectant un capteur (10,110), au moins une borne (B1,B2) de ce capteur étant reliée à une résistance de tirage (21,22,121), ledit système étant **caractérisé en ce qu'**il comporte :

   - des moyens pour appliquer, à au moins une résistance de tirage (21,22,121), une tension de polarisation de test (Vtest_h,Vtest_l) comprenant au moins une caractéristique prédéfinie différente d'une caractéristique correspondante d'une tension de polarisation nominale de cette résistance, ladite caractéristique prédéfinie étant par exemple un paramètre de la tension telle qu'une amplitude ou une nature continue ou alternative de la tension ;
   - des moyens (C1,C2) pour mesurer la tension différentielle résultante aux bornes du capteur ; et

- des moyens pour déterminer, en fonction d'au moins une caractéristique de la tension différentielle mesurée correspondant à la caractéristique prédéfinie des tensions de polarisation de test, si le capteur présente un court-circuit.

**10.** Système de détection d'un court-circuit selon la revendication 9, **caractérisé en ce que** les moyens pour appliquer les tensions de polarisation de test comprennent un convertisseur numérique analogique (31,32).

**Patentansprüche**

**1.** Verfahren zur Erfassung eines einen Sensor (10, 110) beeinträchtigenden Kurzschlusses, wobei wenigstens ein Anschluss (B1, B2) dieses Sensors mit einem Ziehwiderstand (21, 22, 121) verbunden ist, wobei das Verfahren **dadurch gekennzeichnet ist, dass** es darin besteht:

- an wenigstens einen Ziehwiderstand (21, 22, 121) eine Testpolarisationsspannung (Vtest_h, Vtest_l) anzulegen (E20, F10), die wenigstens ein vordefiniertes Merkmal, das von einem entsprechenden Merkmal einer Nennpolarisationsspannung (Vnom_h, Vnom_l) dieses Widerstandes verschieden ist, umfasst, wobei das vordefinierte Merkmal beispielsweise ein Parameter der Spannung, wie eine Amplitude oder eine Gleich- oder Wechselart der Spannung ist,
- die resultierende Differenzspannung (V2, V3) an den Anschlüssen des Sensors zu messen (E30, F20), und
- in Abhängigkeit von wenigstens einem Merkmal der gemessenen Differenzspannung, das dem vordefinierten Merkmal der Testpolarisationsspannungen entspricht (E40, F30), zu bestimmen (E50, E60, F40, F50), ob der Sensor einen Kurzschluss aufweist.

**2.** Verfahren zur Erfassung eines Kurzschlusses nach Anspruch 1, **dadurch gekennzeichnet, dass** bestimmt wird, dass der Sensor einen Kurzschluss aufweist, wenn das Merkmal der gemessenen Differenzspannung von einem entsprechenden Merkmal, das für eine an den Anschlüssen des Sensors gemessene Differenzspannung erwartet wird, wenn dieser keinen Kurzschluss aufweist, verschieden ist.

**3.** Verfahren zur Erfassung eines Kurzschlusses nach Anspruch 1 oder 2, **dadurch gekennzeichnet, dass**:

- jeder Anschluss (B1, B2) des Sensors (10) mit einem Ziehwiderstand (21, 22) verbunden ist,
- zum Anlegen der Testpolarisationsspannung (Vtest_h, Vtest_l) an jeden Widerstand, an die beiden Ziehwiderstände (21, 22) ein Wechselsignal mit einer vorbestimmten Frequenz, die von einer Nutzfrequenz des Sensors verschieden ist, angelegt wird, und
- bestimmt wird, dass der Sensor einen Kurzschluss aufweist, wenn die resultierende Differenzspannung einen Wechselanteil mit dieser vorbestimmten Frequenz umfasst.

**4.** Verfahren zur Erfassung eines Kurzschlusses nach Anspruch 1 oder 2, **dadurch gekennzeichnet, dass** es ferner darin besteht, eine Nenndifferenzspannung (V1) an den Anschlüssen des Sensors (B1, B2) zu messen, wenn die Ziehwiderstände (21, 22, 121) durch die Nennpolarisationsspannungen (Vnom_h, Vnom_l) beaufschlagt werden, und dass bestimmt wird (E50), dass dieser Sensor einen Kurzschluss aufweist, wenn die resultierende Differenzspannung, die nach Anlegen der Testpolarisationsspannungen gemessen wird, im Wesentlichen gleich der Nenndifferenzspannung ist.

**5.** Verfahren zur Erfassung eines Kurzschlusses nach Anspruch 4, **dadurch gekennzeichnet, dass** zum Anlegen der Testpolarisationsspannung an jeden Widerstand ein kontinuierliches Signal angelegt wird.

**6.** Verfahren zur Erfassung eines Kurzschlusses nach Anspruch 5, **dadurch gekennzeichnet, dass** das kontinuierliche Signal eine Amplitude hat, die von der Amplitude der Nennpolarisationsspannung des Widerstandes verschieden ist.

**7.** Verfahren zur Erfassung eines Kurzschlusses nach Anspruch 4, **dadurch gekennzeichnet, dass** zum Anlegen der Testpolarisationsspannung an jeden Widerstand ein Wechselsignal mit einer vorbestimmten Frequenz, die von einer Nutzfrequenz des Sensors verschieden ist, angelegt wird.

**8.** Verfahren zur Erfassung eines Kurzschlusses nach Anspruch 7, **dadurch gekennzeichnet, dass** jeder Anschluss des Sensors mit einem Ziehwiderstand verbunden ist und dass zum Anlegen der Testpolarisationsspannung die an die Widerstände angelegten Wechselsignale gegenphasige Sinussignale sind.

**9.** System (1, 101) zur Erfassung eines einen Sensor (10, 110) beeinträchtigenden Kurzschlusses, wobei wenigstens ein Anschluss (B1, B2) dieses Sensors mit einem Ziehwiderstand (21, 22, 121) verbunden ist, wobei das System **dadurch gekennzeichnet ist, dass** es umfasst:

- Mittel zum Anlegen, an wenigstens einen Ziehwiderstand (21, 22, 121), einer Testpolarisationsspannung (Vtest_h, Vtest_l), die wenigstens ein vordefiniertes Merkmal, das von einem entsprechenden Merkmal einer Nennpolarisationsspannung dieses Widerstandes verschieden ist, umfasst, wobei das vordefinierte Merkmal beispielsweise ein Parameter der Spannung, wie eine Amplitude oder eine Gleich- oder Wechselart der Spannung ist,
- Mittel (C1, C2) zum Messen der resultierenden Differenzspannung an den Anschlüssen des Sensors, und
- Mittel, um in Abhängigkeit von wenigstens einem Merkmal der gemessenen Differenzspannung, das dem vordefinierten Merkmal der Testpolarisationsspannungen entspricht, zu bestimmen, ob der Sensor einen Kurzschluss aufweist.

**10.** System zur Erfassung eines Kurzschlusses nach Anspruch 9, **dadurch gekennzeichnet, dass** die Mittel zum Anlegen der Testpolarisationsspannungen einen Digital/Analog-Wandler (31, 32) umfassen.

## Claims

**1.** A method of detecting a short circuit affecting a sensor (10, 110), at least one terminal (B1, B2) of the sensor being connected to a bias resistor (21, 22, 121), said method being **characterized in that** it consists in:

• applying (E20, F10) to at least one bias resistor (21, 22, 121) at least one test bias voltage (Vtest_h, Vtest_l) having at least one predefined characteristic that is different from a corresponding characteristic of a nominal bias voltage (Vnom_h, Vnom_l) of the resistor, said predefined characteristic being for example a parameter of the voltage such as an amplitude or a DC or AC nature of the voltage;
• measuring (E30, F20) the resulting differential voltage (V2, V3) across the terminals of the sensor; and
• as a function of at least one characteristic of the measured differential voltage corresponding to the predefined characteristic of the test bias voltages (E40, F30), determining (E50, E60, F40, F50) whether the sensor presents a short circuit.

**2.** A method of detecting a short circuit according to claim 1, **characterized in that** it is determined that the sensor presents a short circuit if the characteristic of the measured differential voltage is different from a corresponding characteristic as expected for a differential voltage measured across the terminals of the sensor when the sensor does not present a short circuit.

**3.** A method of detecting a short circuit according to claim 1 or claim 2, **characterized in that**:

• each terminal (B1, B2) of the sensor (10) is connected to a bias resistor (21, 22);
• in order to apply the test bias voltage (Vtest_h, Vtest_l) to each resistor, an AC signal at a predetermined frequency different from a working frequency of the sensor is applied to the two bias resistors (21, 22); and
• it is determined that the sensor presents a short circuit if the resulting differential voltage includes an AC component at said predetermined frequency.

**4.** A method of detecting a short circuit according to claim 1 or claim 2, **characterized in that** it further consists in measuring a nominal differential voltage (V1) across the terminals of the sensor (B1, B2) when the bias resistors (21, 22, 121) are fed with nominal bias voltages (Vnom_h, Vnom_l), and **in that** it is determined (E50) that the sensor presents a short circuit if the resulting differential voltage measured after applying the test bias voltages is substantially equal to the nominal differential voltage.

**5.** A method of detecting a short circuit according to claim 4, **characterized in that**, in order to apply the test bias voltage, a DC signal is applied to each resistor.

**6.** A method of detecting a short circuit according to claim 5, **characterized in that** the DC signal has an amplitude different from the amplitude of the nominal bias voltage of the resistor.

**7.** A method of detecting a short circuit according to claim 4, **characterized in that**, in order to apply the test bias voltage, an AC signal at a predetermined frequency different from a working frequency of the sensor is applied to each resistor.

8. A method of detecting a short circuit according to claim 7, **characterized in that** each terminal of the sensor is connected to a bias resistor, and **in that**, in order to apply the test bias voltage, the AC signals applied to the resistors are two sinusoidal signals in phase opposition.

9. A system (1, 101) for detecting a short circuit affecting a sensor (10, 110), at least one terminal (B1, B2) of the sensor being connected to a bias resistor (21, 22, 121), said system being **characterized in that** it comprises:

   • means for applying, to at least one bias resistor (21, 22, 121), a test bias voltage (Vtest_h, Vtest_l) having at least one predefined characteristic different from a corresponding characteristic of a nominal bias voltage of said resistor, said predefined characteristic being for example a parameter of the voltage such as an amplitude or a DC or AC of the voltage;
   • means (C1, C2) for measuring the resulting differential voltage across the terminals of the sensor; and
   • means for determining, as a function of at least one characteristic of the measured differential voltage corresponding to the predefined characteristic of the test bias voltages, whether the sensor presents a short circuit.

10. A system of detecting a short circuit according to claim 9, **characterized in that** the means for applying the test bias voltages comprise a digital-to-analog converter (31, 32).

EP 2 694 988 B1

**FIG.1**

40

31

R2 21

10

C1

1

B1

11 R1

12 L1

B2

51

52

R2 22

32

40

---

Détection d'une tension différentielle V1 nulle aux bornes du capteur 10 lors de l'application des tensions nominales Vnom_l et Vnom_h — E10

↓

Application des tensions de test Vtest_l et Vtest_h aux résistances de tirage — E20

**FIG.3**

↓

Mesure de la tension différentielle V2 résultante aux bornes du capteur 10 — E30

↓

E40 — ◇ V1 = V2 ? ◇ — NON

OUI ↓

E50 — Détection d'un court-circuit différentiel

E60 — Comportement normal du capteur 10

13

# FIG.2A

Vnom_h

# FIG.2B

Vnom_h + Vtest_h

## FIG.4

Vnom_h + Vtest_h

40

31

21

10

B1

11

V3

12

B2

C1

1

51

52

22

Vnom_l + Vtest_l

32

40

## FIG.6

140

131

Vnom_h + Vtest_h

121

110

B1

111

112

B2

C2

101

152

M

Injection d'un signal alternatif S2
en mode commun sur les résistances
de tirage 21 et 22    F10

↓

Mesure de la tension différentielle V3    F20
résultante aux bornes du capteur 10

↓

F30    Composante
à la fréquence f2    NON
dans V3 ?

OUI

F40    Détection d'un
court-circuit à la masse
mécanique

F50    Comportement
normal du capteur 10

**FIG.5**

16

**EP 2 694 988 B1**

## RÉFÉRENCES CITÉES DANS LA DESCRIPTION

**Documents brevets cités dans la description**

- US 20060036381 A

- WO 8910542 A